# EUROPEAN PATENT SPECIFICATION

(11) **EP 0 366 343 B1**
(45) Date of publication and mention of the grant of the patent: **20.03.1996**
(21) Application number: 89310697.1
(22) Date of filing: 18.10.1989
(51) Int. Cl.: H01L 21/336, H01L 21/3105, H01L 21/316

(54) **Integrated circuit fabrication, including low temperature method for making silicide structures**
Integrierte Schaltungherstellung, unter Anwendung eines Niedrig-Temperatur-Verfahrens zur Herstellung von Silicid-Strukturen
Fabrication d'un circuit intégré, comprenant une méthode à faible température pour faire des structures en silicide

(30) Priority: 28.10.1988 US 264481
(43) Date of publication of application: 02.05.1990
(73) Proprietor: AT&T Corp., New York, NY 10013-2412 (US)
(72) Inventor: Chen, Min-Liang, Wescosville Pennsylvania 18106 (US); Leung, Chung Wai, Allentown Pennsylvania 18104 (US); Martin, Edward P., Jr., Bethlehem Pennsylvania 18017 (US)
(74) Representative: Watts, Christopher Malcolm Kelway, Dr.

(56) References cited:
- US-A- 4 743 564
- JOURNAL OF THE ELECTROCHEMICAL SOCIETY, vol. 134, no. 2, February 1987, pp. 430-437, Manchester, NH, US ; R.A. LEVY et al.: "A new LPCVD technique of producing borophosphosilicate glass films by injection of miscible liquid precursors"
- JOURNAL OF VACUUM SCIENCE & TECHNOLOGY, vol. B4, no. 3, May/June 1986, pp. 732-744, American Vacuum Society, New York, US ; F.S. BECKER et al.: "Process and film characterization of low pressure tetraethylorthosilicateborophosphosilicate glass"
- JOURNAL OF THE ELECTROCHEMICAL SOCIETY, vol. 134, no. 3, March 1987, pp. 657-664, Manchester, NH, US ; D.S. WILLIAMS et al.: "LPCVD of borphosphosilicate glass from organic reactants"
- JOURNAL OF THE ELECTROCHEMICAL SOCIETY, vol. 134, no. 11, November 1987, pp. 2923-2931, Lanchester, NH, US ; F.S. BECKER et al.: "Low pressure deposition of doped SiO2 by pyrolysis of tetraethylorthosilicate (TEOS)"

## Description

### Technical Field

This invention relates to semiconductor integrated circuits, and more particularly to circuits with field effect transistors, which include metal silicide structures.

### Background of the Invention

One of the most common devices used in integrated circuits, at the present time, is the field effect transistor (FET), which has source and drain regions, as well as a gate electrode. Electrical contacts to a FET are typically made through a dielectric layer, which covers the device surface and is patterned with openings which expose selected portions of the device regions (such as source, drain, or gate). The openings (termed "windows") are filled with a conductor, typically metal, to form electrical connections to the device regions.

Silicides are commonly used to improve electrical connections to the source, gate, and drain regions. For example, a layer of titanium silicide (TiSi₂), tantalum silicide (TaSi₂), or cobalt silicide (CoSi₂), may be used to improve the connections. If the silicide region is produced by a self-aligning process with respect to this device region, the resulting structure is commonly referred to as a salicide structure. That is, a s elf-a ligned silicide

One exemplary salicide structure is formed by depositing a titanium layer on silicon and heating to react the titanium and silicon to form TiSi₂. Unreacted titanium (which does not contact silicon) is etched away. The resulting salicide contacts the source and drain regions, and it may also be used to contact the gate electrode.

After the source and drain salicide regions have been formed, standard integrated circuit processing typically involves blanket deposition of a dielectric, often a silicate glass containing both boron and phosphorus. Later, this glass, commonly referred to by the acronym BPSG, is often flowed at a temperature of approximately 950^{o}C to produce a smooth dielectric surface which is needed for subsequent processing steps. The term "smooth" is used to mean locally smooth, i.e., smooth over a distance of approximately 5µ, so that integrated circuit features which are close to each other are covered by a dielectric with an essentially smooth surface. Windows are then formed, and a metal, typically aluminum, is then deposited through the windows in the dielectric layer to contact the salicide.

However, it has been found that the TiSi₂ nucleates and its surface become very rough as the grain size increases at elevated temperatures, such as 950°C (which typifies BPSG flow). Additionally, the resistivity of the TiSi₂ increases, in many instances, by approximately an order of magnitude when heated to 950°C. Both effects are often undesirable for the electrical contacts to the regions. Thus, the elevated temperature required to flow and smooth the BPSG greatly limits the usefulness of TiSi₂ for semiconductor device regions. Before silicides came into use, a layer of undoped glass was sometimes deposited before a layer of BPSG to prevent diffusion of the boron and phosphorous into the source and drain regions of the device. However, silicides form an effective diffusion resistant layer to boron and phosphorous. Consequently, an undoped glass has not been necessary for this purpose in silicided devices.

In order to deposit BPSG a variety of chemical precursors have been used. One precursor is TEOS (tetraethoxysilane) doped with boron and phosphorous (often termed "BPTEOS"). An example of the use of BPTEOS is provided by Becker et al., 'Process and Film Characterization of Low-pressure Tetraorthosilicate-borophosphosilicate Glass', J. Vac. Sci. Technol. B4(3)pp. 732-744, May/Jun 1986. The publication discusses the properties of BPTEOS dielectric with boron and phosphorous dopants in a wide range of concentrations and also discusses the reflow properties of BPTEOS at a range of temperatures between 680°C and 900°C. The publication does not suggest the applicability of BPTEOS to silicide structures. Another example of deposition of BPSG from BPTEOS is given by R.A. Levy et al. in 'A New LPCVD Technique of Producing Borophosphosilicate Glass Films by Injection of Miscible Liquid Precursors' J. Electrochem. Soc., vol 134, no 2, February 1987, pages 430-437.

Another precursor for BPSG is diacetoxyditertiarybutoxysilane (DADBS). A discussion of the applications of DADBS to tantalum silicide structures is contained in: Levy et al, 'Low-Pressure Chemical Vapor Deposition of Borophosphosilicate Glass Films Produced by Injection of Miscible DADBS-TMP-TMP Liquid Sources', J. Electrochem. Soc., Vol. 134, No. 7, 1744-9. July 1987. However, DADBS has a lower vapor pressure than TEOS and consequently requires a more complex delivery system. The Levy et al publication has a photograph of a polysilicon/silicide/oxide/BPSG stacked structure.

US-A-4 743 564 discloses a method for manufacturing a CMOS device which includes forming tungsten silicide contacts to the source, drain and gate, forming a SiO₂ layer covering the silicide by chemical vapour deposition (CVD) and forming a PSG or BPSG layer over the SiO₂ layer. The SiO₂ and PSG layers are then patterned and the PSG layer is flowed at about 1000°C.

### Summary of the Invention

According to the invention there is provided a method as set out in the claims.

The temperature of 800°C is sufficiently low that the desired characteristics, with respect to resistivity and grain size of the TiSi₂, are not adversely affected by the heating step.

In a manufacturing environment, sharp corners may occur at the upper edges of the gate structure. When the dielectric glass is flowed, pinholes may occasionally occur at the sharp corners. The occurrence of pinholes are prevented by the deposition of a layer of TEOS before the BPTEOS.

### Brief Description of the Drawing

Fig. 1 is is a cross-sectional view of of a device useful in understanding this invention,
Fig. 2 is a cross-sectional view of an illustrative embodiment of a device according to this invention; and
Fig. 3 is a cross-sectional view of the device depicted in Fig. 2 after subsequent processing steps.

### Detailed Description

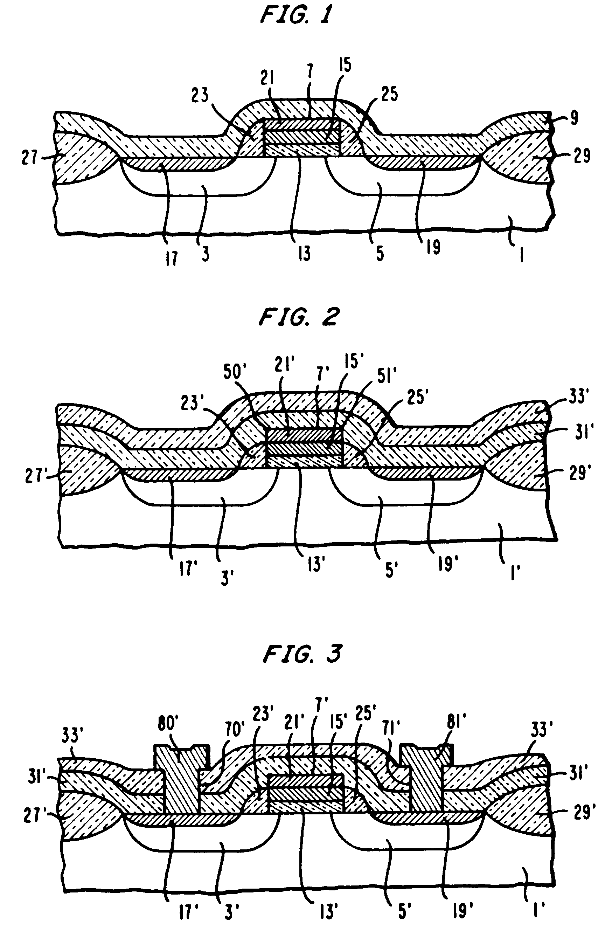

For reasons of clarity, the elements of the device depicted are not drawn to scale. Depicted in Fig. 1 are substrate 1, a transistor having source and drain regions 3 and 5, respectively, a gate structure 7, and dielectric glass layer 9. Substrate 1 may have an upper epitaxial layer, if desired. The gate has, as is well known, a doped polysilicon conductor 15 overlying a thin oxide 13. Silicide region 21 is on top of conductor 15. Spacers 23 and 25 are positioned on either side of gate 7. Field oxides 27 and 29 are positioned adjacent source and drain regions 3 and 5, respectively. The source and drain regions 3 and 5 include silicide regions 17 and 19, respectively. (Silicide regions 17 and 19 may be eliminated, if desired). Silicide regions 7,17 and 19 are formed by techniques known to those skilled in the art. Briefly, a thin layer (typically several tens of nm (several hundred Angstroms) of titanium is blanket deposited. The layer is subjected to a rapid thermal annealing, typically, in a nitrogen atmosphere at a temperature of approximately 600°C for a few minutes. During the annealing step a portion of the metal reacts with the underlying silicon material. Then, the unreacted metal is etched away. Finally, another rapid thermal annealing in nitrogen at approximately 900°C for a minute or so completes the silicide formation.

The invention is applicable to transistors with various source and drain doping profiles, including lightly doped drain (LDD) structures. The structure depicted, except for the dielectric layer 9, may be formed by well-known techniques which therefore need not be described in further detail.

Fabrication of the dielectric layer 9 will be discussed in some detail. The dielectric layer 9 is formed from the decomposition of tetraethoxysilane ((Si(OC₂H₅)₄, abbreviated TEOS)) which includes boron and phosphorus. As mentioned before, TEOS doped with both boron and phosphorus is commonly referred to as BPTEOS.

It will be readily appreciated by those skilled in the art that the acronyms come from the gases and liquids used to deposit the dielectric layer. Thus, the expression, "depositing a layer of TEOS", is generally understood by those skilled in the art to mean the deposition of a dielectric glass layer by decomposition of TEOS in a reactor. The resulting dielectric layer is an oxide of silicon which exhibits better step coverage than oxides deposited by other means. Furthermore, TEOS is comparatively safer to handle than, for example, silane.

The expression, "depositing a layer of BPTEOS", is generally understood by those skilled in the art to mean the deposition of a dielectric layer by decomposition of TEOS in the presence of phosphorous and boron dopants in a reactor. The phosphorous and boron dopants may be obtained, for example, from trimethylphosphite, phosphine, trimethylborate, trimethylphosphate, triethylphosphite, or triethylphosphate. The expression "doped dielectric", as used herein, includes dielectrics with at least one dopant which promotes flow present in an amount of at least one percent by weight. Examples of such dopants are boron, phosphorous, germanium, and arsenic.

In the present invention, boron and phosphorus are each present in amounts ranging from approximately 3.5 to 4.5 percent by weight. Amounts of either boron or phosphorus greater than 5.0 percent are undesirable because boric acid or PBO₄ particulates may form. Amounts less than 3.5 percent are undesirable because the deposited dielectric will not flow properly during subsequent smoothing steps. The specified range for boron and phosphorus allows good flow without permitting too much thinning of the dielectric on hills and too much thickening of the dielectric in valleys. After the BPTEOS layer is deposited, it is smoothed by heating it and allowing it to flow. The flow rounds comers and leads to local smoothing; i.e., within a distance of approximately 5µm, of the dielectric. The precise distance will obviously also depend upon the depth of the dielectric. Global planarization, i.e., over the entire wafer, is not required. However, it should be appreciated that the film is conformally deposited and has good step coverage. If step coverage is measured as x/y, where x is the minimum thickness on the vertical wall and y is the maximum thickness on the top horizontal surface, BPTEOS has a step coverage of about 0.9, while TEOS and BPSG have step coverages of about 0.5 and 0.7, respectively.

The BPTEOS dielectric glass just described flows adequately, i.e., flows sufficiently to form a locally smooth surface, when maintained at a temperature of approximately 800°C ± 50°C in nitrogen for a time between one half hour and two hours. It is also believed that the flow eliminates voids. The 800°C temperature does not degrade the desirable properties of the underlying salicides. After the dielectric smoothing has been completed, integrated circuit fabrication continues in a conventional and well-known manner with, for example, patterning of the dielectric 9 to expose the source and drain regions of the device.

Fig. 2 illustrates an exemplary embodiment of the present invention. Depicted in Fig. 2 are substrate 1', a transistor with source and drain regions 3' and 5', respectively, and a gate structure 7'.

As in Fig. 1, the gate has a conductor 15′ overlying a thin oxide 13'. Silicide region 21' is on top of conductor 15'. Spacers 23' and 25' are positioned on either side of gate 7'. However, it should be noted that spacers 25' and 23' are not as tall as gate 7'. Consequently, gate 7' has sharp corners, or edges, 50' and 51'. The occurrence of sharp corners, such as 50′ and 51' in Fig. 2, can be due to a variety of manufacturing problems, including over-etching of spacers 25' and 23' and growth of silicide region 21' during its formation.

Sharp corners or edges on gate structure 7' may cause thinning, or pinholes, in the BPTEOS layer after it is flowed. In addition, the sharp corners or edges can cause high electric fields which may cause a breakdown of the BPTEOS layer if it is too thin near the corners or edges.

Fig. 2 illustrates a solution to the aforementioned problem. In Fig. 2, a layer of TEOS 31' is deposited prior to the deposition of BPTEOS layer 33'. Layer 33' is doped with boron and phosphorous to promote subsequent flow. Each dopant is preferably present in amounts ranging from 3.5 to 4.5 percent by weight. The TEOS layer will not flow at the temperature used to flow the BPTEOS. The thickness of TEOS layer 31' is typically at least 100 nm (1000°Å) to combat the pinhole and breakdown problems. For present generation devices constructed in 0.9 micrometer (micron) technology, the thickness of TEOS layer 31' is 200 nm ± 50 nm (2000Å ± 500Å), and the thickness of the BPTEOS layer 33' is typically 350 ± 50 nm (3500 ± 500 Å) TEOS layer 31' covers corners 50' and 51', and helps to prevent thinning of BPTEOS layer 33' after the 800°C flow. Consequently, the chances of pinholes and breakdown are substantially diminished. The desirable properties of silicide regions 17', 19', and 21' are preserved. Fig. 3 shows the device of Fig. 2 after layer 33' has flowed and windows 70' and 71' have been opened in layers 31' and 33' above silicide regions 17' and 19', respectively. Metal contacts 80' and 81' have been deposited by standard techniques in windows 70' and 71' to contact silicide regions 17' and 19'. A similar windowing and metal contacting is, of course, also performed in the structure of Fig. 1.

Embodiments other than those specifically described are contemplated. For example, silicides other than TiSi₂ such as CoSi₂ may be used. The inventive process illustrated here is, of course, applicable to both salicide and silicide structures, i.e., self-alignment of the silicide is not a prerequisite for application of the invention. Furthermore, the dielectric structure of the present invention is applicable to devices using substrates other than silicon, e.g., devices utilizing III-V substrates. In addition, the embodiments illustrated in Figs. 2-3 may use other flowable dielectrics for layer 33' and other non-flowable dielectrics (or dielectrics which flow at a higher temperature than the flow temperature of layer 33') for layer 31'.

## Claims

1. A method of silicon semiconductor integrated circuit fabrication comprising the steps of:
forming titanium silicide source (17'), gate (21') and drain (19') regions of a field effect transistor on a silicon substrate (1'),
depositing a first dielectric layer (31) at least 100 nm thick over said titanium silicide regions by the decomposition of TEOS,
depositing a second dielectric layer (33') having a thickness between 300 nm and 400 nm doped with boron and phosphorus, on said first dielectric layer by the decomposition of BPTEOS, said boron and phosphorus each being present in amounts in the range 3.5 to 4.5 weight percent,
flowing said second dielectric layer by heating it to a temperature of 800°C in a nitrogen atmosphere for a time between one-half and two hours.

2. The method of claim 1
in which a silicide (7') is formed on the gate of said field effect transistor.

3. The method of claim 1 or 2 in which said silicide is a salicide.

4. The method of any of the preceding claims in which the thickness of said first dielectric layer (31') is between 150 nm and 250 nm.

## Patentansprüche

1. Verfahren zur Herstellung von integrierten Siliciumhalbleiterschaltungen mit den folgenden Schritten:
Bildung von Titansilicid-Source-(17')-, Gate(21')- und Drain-(19')-Zonen eines Feldeffekttransistors auf einem Siliciumsubstrat (1'),
Abscheidung einer mindestens 100 nm dicken ersten Nichtleiterschicht (31) auf den Titansilicid-Zonen durch die Zersetzung von TEOS,
Abscheidung einer zweiten, mit Bor und Phosphor dotierten Nichtleiterschicht (33') mit einer Dicke zwischen 300 nm und 400 nm auf der ersten Nichtleiterschicht durch die Zersetzung von BPTEOS, wobei das Bor und der Phosphor jeweils in Mengen im Bereich von 3,5 bis 4,5 Gewichtsprozent vorliegen,
Verfließenlassen der zweiten Nichtleiterschicht, indem sie in einer Stickstoffatmosphäre eine halbe Stunde bis zwei Stunden lang auf 800°C erhitzt wird.

2. Verfahren nach Anspruch 1, wobei auf dem Gate des Feldeffekttransistors ein Silicid (7') gebildet wird.

3. Verfahren nach Anspruch 1 oder 2, wobei es sich bei dem Silicid um ein Salicid handelt.

4. Verfahren nach einem der vorhergehenden Ansprüche, wobei die Dicke der ersten Nichtleiterschicht (31') zwischen 150 nm und 250 nm liegt.

## Revendications

1. Méthode de fabrication de circuit intégré à semiconducteur de silicium comprenant les étapes de:
formation de zones de source (17'), grille (21') et drain (19') en siliciure de titane d'un transistor à effet de champ sur un substrat (1') en silicium,
dépôt d'une première couche diélectrique (31) d'une épaisseur d'au moins 100 nm par dessus lesdites zones de siliciure de titane par la décomposition de TEOS,
dépôt d'une deuxième couche diélectrique (33') d'une épaisseur entre 300 mm et 400 mm dopée au boron et phosphore, sur ladite première couche diélectrique par la décomposition de BPTEOS, lesdits boron et phosphore étant chacun présents en quantités allant de 3,5 à 4,5 pour cent en poids,
écoulement de ladite deuxième couche diélectrique en la chauffant à une température de 800°C dans une atmosphère d'azote entre une demi-heure et deux heures.

2. Méthode de la revendication 1
dans laquelle un siliciure (7') est formé sur la grille dudit transistor à effet de champ.

3. Méthode de la revendication 1 ou 2, dans laquelle ledit siliciure est un siliciure auto-aligné.

4. Méthode de l'une quelconque des revendications précédentes dans laquelle l'épaisseur de ladite première couche diélectrique (31') est.entre 150 nm et 250 nm.
